# EUROPÄISCHE PATENTSCHRIFT

(11) **EP 3 176 892 B1**
(45) Veröffentlichungstag und Bekanntmachung des Hinweises auf die Patenterteilung: **15.07.2020**
(21) Anmeldenummer: 16200613.4
(22) Anmeldetag: 25.11.2016
(51) Int. Cl.: H02H 3/06, H02H 3/093, H02H 3/07, G01R 19/165

(54) **VORRICHTUNG ZUR DETEKTION EINES ÜBERSTROMS**
DEVICE FOR DETECTING OVERFLOW
DISPOSITIF DE DÉTECTION D'UNE SURTENSION

(30) Priorität: 25.11.2015 DE 102015223358
(43) Veröffentlichungstag der Anmeldung: 07.06.2017
(73) Patentinhaber: Phoenix Contact GmbH & Co.KG, 32825 Blomberg (DE)
(72) Erfinder: Fomenko, Alexander, 33605 Bielefeld (DE); Nahles, Guido, 33175 Bad Lippspringe (DE); Wölk, Gerhard, 32816 Schieder-Schwalenberg (DE)
(74) Vertreter: RCD Patent Giesen, Schmelcher & Griebel Patentwanwälte PartG mbB

(56) Entgegenhaltungen:
- US-A- 5 627 717
- US-A- 5 994 790
- US-A1- 2010 328 828
- US-A1- 2014 347 774

## Beschreibung

Aus dem Stand der Technik sind zahlreiche Vorrichtungen zur Detektion von Überströmen bekannt.

Beispielsweise ist aus dem US Patent US 5,994,790 eine Vorrichtung bekannt, die in Abhängigkeit von einem gemessen Strom einen Zähler mit unterschiedlicher Schrittweite inkrementiert/dekrementiert und bei Übersteigen eines Referenzwertes den Stromfluss unterbricht. Die veröffentlichte US Patentanmeldung US 2014 / 347 774 A1 wird eine Schrittweite basierend auf einem gemessen Strom anhand einer Look-Up Tabelle bestimmt. Mittels der ermittelten Schrittweite ein Zähler geändert. Ein Vergleich des Zählers mit einem Zählergrenzwert führt bei Überschreiten zu einer Betätigung eines Unterbrechers. Ein weiteres Dokument, das eine Stromunterbrechung offenbart, ist US5627717.

Dabei erweist es sich als großes Problem echte Kurzschlüsse von virtuellen Kurzschlüssen zu unterscheiden. Virtuelle Kurzschlüsse entstehen durch kapazitive Lasten, die sich insbesondere beim Einschalten wie ein Kurzschluss verhalten. D.h. bis die kapazitive Last entsprechend geladen ist fließen teils erhebliche Ströme.

Daher wurden in der Vergangenheit immer wieder Versuche unternommen, diese virtuellen Kurzschlüsse zu erkennen.

Beispielsweise ist aus der DE 10 2012 103 551 A1 eine elektronische Sicherungsvorrichtung bekannt, die einen steuerbaren Schalter in Abhängigkeit von einem Überstrom ausschaltet und in Abhängigkeit der Spannungsänderung am Ausgang wieder einschaltet.

Nachteilig an diesen Vorrichtungen ist, dass sie zunächst von einem Überstrom ausgeht und abschaltet und erst nach einer gewissen Zeit eine Zuschaltung abhängig von einer Wiedereinschaltbedingung ermöglicht. Hierdurch wird häufig eine unnötig lange Zeit benötigt, um eine kapazitive Last aufzuladen. Zudem ist die Erkennung vergleichsweise kompliziert, da eine Speicherung von "historischen" Werten nötig ist. Weiterhin ist bei solchen Anordnung es häufig problematisch, dass nach Öffnung des Schalters die kapazitive Last durch eine parallel liegende resistive Last entladen wird, sodass die Erkennung unter Umständen eine aufzuladende kapazitive (Teil-)Last fälschlich dennoch als Kurzschluss erkennt. Insbesondere erweist sich eine dort beanspruchte Einrichtung in Bezug auf das Anschalten einer kapazitiven Last als problematisch, da hier bereits beim Einschalten die Ausschaltbedingung erfüllt ist und somit kein historischer Spannungswert zum Vergleich vorliegt.

Der Erfindung liegt die Aufgabe zu Grunde, verbesserte und kostengünstige Vorrichtungen zur Detektion eines Kurzschlusses zu schaffen, die einen oder mehrere Nachteile aus dem Stand der Technik vermeidet.

Die Lösung der Aufgabe erfolgt erfindungsgemäß durch die Merkmale des unabhängigen Anspruchs. Vorteilhafte Ausgestaltungen der Erfindung sind in den Unteransprüchen angegeben.

Nachfolgend wird die Erfindung unter Bezugnahme auf die anliegende Zeichnung anhand bevorzugter Ausführungsformen näher erläutert.

Es zeigen
- Fig. 1: eine Übersichtsdarstellung von Ausführungsformen gemäß der Erfindung,
- Fig. 2: ein Flussdiagramm einer alternativen Ausführungsform und
- Fig. 3: ein Flussdiagramm einer ersten Ausführungsform der Erfindung.

Nachfolgend wird die Erfindung eingehender unter Bezugnahme auf die Figur dargestellt werden. Dabei ist anzumerken, dass unterschiedliche Aspekte beschreiben werden, die jeweils einzeln oder in Kombination zum Einsatz kommen können. D.h. jeglicher Aspekt kann mit unterschiedlichen Ausführungsformen der Erfindung verwendet werden soweit nicht explizit als reine Alternative dargestellt.

Weiterhin wird nachfolgend der Einfachheit halber in aller Regel immer nur auf eine Entität Bezug genommen werden. Soweit nicht explizit vermerkt, kann die Erfindung aber auch jeweils mehrere der betroffenen Entitäten aufweisen. Insofern ist die Verwendung der Wörter "ein", "eine" und "eines" nur als Hinweis darauf zu verstehen, dass in einer einfachen Ausführungsform zumindest eine Entität verwendet wird.

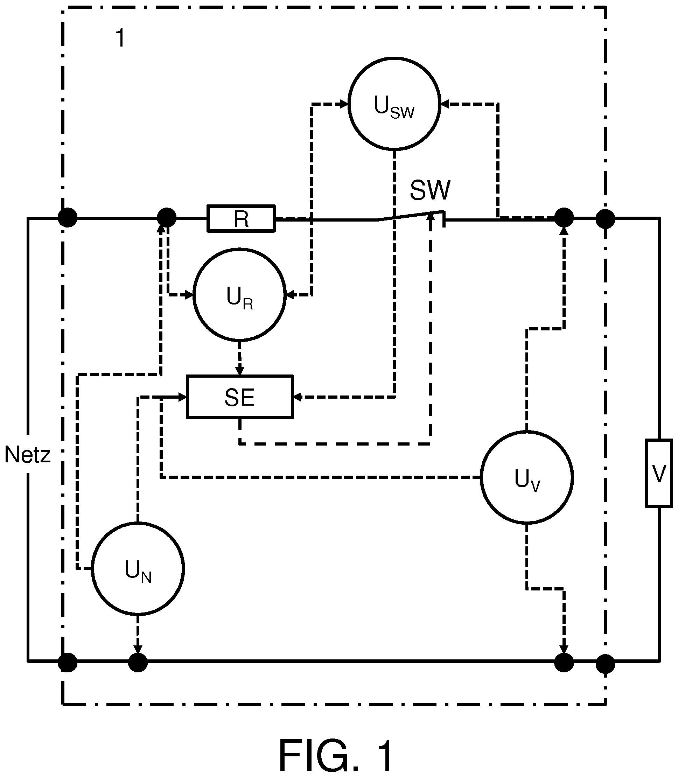

In einer alternativen Ausführungsform, welche beispielhaft in der Figur 1 enthalten ist, weist eine Vorrichtung 1 zur Detektion eines Überstromes einen Strommesser U_{R}, einen ersten Zähler Z_{I} und einen Schalter SW auf. Zur besseren Übersicht ist die Vorrichtung 1 in der Abbildung durch einen strich-punktierten Rahmen umgeben.

Dabei misst der Strommesser U_{R} einen Strom I durch die Vorrichtung 1. Hierfür ist im Prinzip jede Form der Strommessung möglich, sei es durch ein induziertes magnetisches Feld (z.B. Rogowski-Spule, Hall-Sensor) oder aber durch Spannungsmessung an einem Shunt-Widerstand R oder dergleichen.

Der Schalter SW ist geeignet einen Stromfluss durch die Vorrichtung 1 zu unterbrechen. Im Prinzip können hier jegliche Art von Schalter zum Einsatz kommen, z.B. ein mechanischer Schalter oder ein elektrischer Schalter, z.B. ein gesteuerter (Feld-Effekt-) Transistor.

Wenn der Strommesser U_{R} einen Strom I misst, der einen ersten Strom-Schwellwert I_{ref,1} übersteigt, d.h. I>I_{ref,}1 wird der erste Zähler Z_{I} um eine erste Schrittweite INC₁ in eine erste Richtung geändert wird. Im vorliegenden Beispiel wird angenommen, dass z.B. die erste Schrittweite 1 beträgt und die Richtung einer Addition "+" entspricht. Weiterhin wir angenommen, dass der erste Strom-Schwellwert I_{ref,1} beispielsweise dem 1.1 fachen des Nennstromwertes entspricht, für den die Vorrichtung 1 ausgelegt ist.

Ohne weiteres wird jedoch für den Fachmann offenbar, dass auch andere äquivalente Implementierungen gewählt werden können, bei denen z.B. die Richtung einer Subtraktion entspricht.

Wenn der Strommesser U_{R} einen Strom I misst, der einen zweiten Schwellwert I_{ref,2} übersteigt, wird der erste Zähler Z_{I} um eine zweite Schrittweite INC₂ in die erste Richtung + geändert. Dabei ist der zweite Schwellwert I_{ref,2} betragsmäßig größer ist als der erste Schwellwert I_{ref,1}, und die zweite Schrittweite INC₂ betragsmäßig größer als die erste Schrittweite INC₁. Im vorliegenden Beispiel wird angenommen, dass z.B. die erste Schrittweite 1 beträgt und die Richtung einer Addition "+" entspricht. Beispiel wird angenommen, dass z.B. die zweite Schrittweite 5 beträgt. Weiterhin wir angenommen, dass der zweite Strom-Schwellwert I_{ref,2} beispielsweise dem 1.5 fachen des Nennstromwertes entspricht, für den die Vorrichtung 1 ausgelegt ist.

Der erste Zähler Z_{I} wird nach einer Zähleränderung mit einem Zählergrenzwert Z_{ref} verglichen, wobei bei Erreichen oder Überschreiten des Zählergrenzwertes Z_{ref}, der Schalter SW dauerhaft so angesteuert wird, dass der Stromfluss unterbrochen wird. Andernfalls wird der Schalter SW für eine vorbestimmte Zeit tₐᵤₛ so angesteuert, dass der Stromfluss unterbrochen wird.

D.h. es wird eine Ausschaltbedingung formuliert, sodass der Regelfall der Stromfluss ist. Nur im Fall, das sicher ein Kurzschluss erkannt wird, wird eine dauerhafte Abschaltung veranlasst. In allen anderen Überstromfällen wird nur kurzfristig unterbrochen.

Ansteuern kann dabei ein aktives Ansteuern ("Öffnen") oder ein passives Unterlassen ("Nicht-Schließen") sein und hängt von der Art des Schalters SW ab. D.h. der Schalter SW kann sowohl als Öffner als auch als Schließer ausgeführt sein.

In einer weiteren vorteilhaften Ausgestaltung wird, wenn der Strommesser U_{R} nachfolgend zu einer temporären Unterbrechung des Stromflusses einen Strom I misst, der den ersten Strom-Schwellwert I_{ref,1} nicht übersteigt, der erste Zähler Z_{I} um eine dritte Schrittweite INC₃ in eine zweite Richtung geändert, wobei die zweite Richtung unterschiedlich ist von der ersten Richtung. Im vorliegenden Beispiel wird angenommen, dass z.B. die dritte Schrittweite ebenfalls 1 beträgt und die Richtung einer Subtraktion "-" entspricht.

In einer weiteren vorteilhaften Ausgestaltung weist die Vorrichtung 1 weiterhin Setzmittel für die Zähler auf, die den ersten Zähler Z_{I} auf einen vorbestimmten Zählerwert zu Beginn des Betriebes setzen. Beispielsweise kann der erste Zähler Z_{I} auf 0 gesetzt werden.

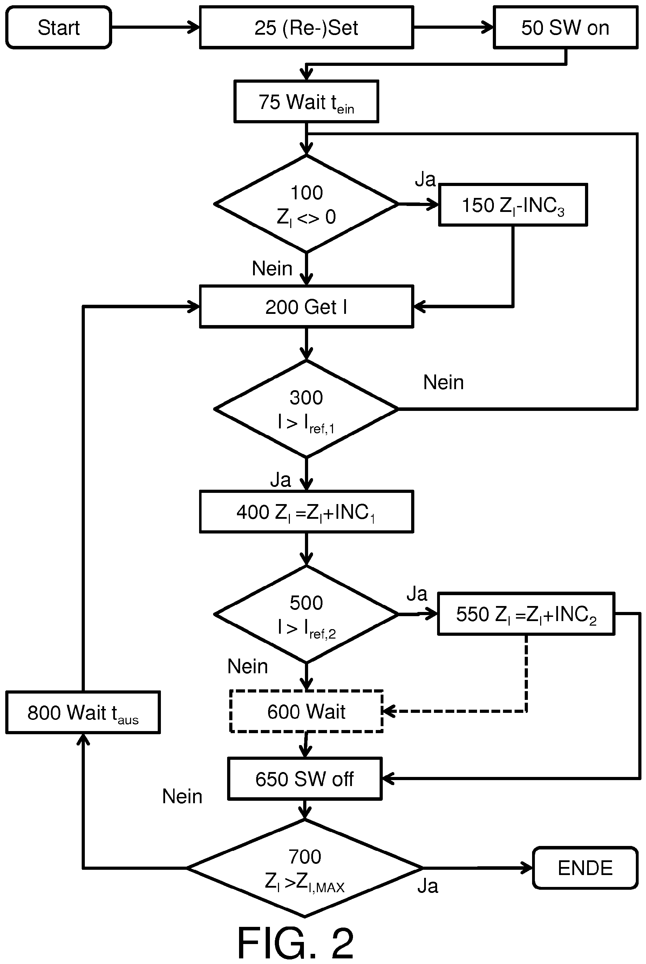

Ein entsprechendes Verfahren kann dann z.B. wie in Figur 2 dargestellt implementiert sein.

In einem ersten Schritt 25 wird der erste Zähler auf den vorbestimmten (Anfangs-) Wert gesetzt.

Anschließend wird in Schritt 50 Schalter SW so angesteuert, dass Strom zur Last V fließt. Nach Ablauf einer vorbestimmten Zeit tₑᵢₙ (Schritt 75) wird in Schritt 100 überprüft, ob der erste Zähler ungleich dem vorbestimmten (Anfangs-) Wert ist. Vorliegend ist angenommen, dass der vorbestimmten (Anfangs-) Wert 0 ist.

Ist der Zähler ungleich dem vorbestimmten (Anfangs-) Wert, so wird der erste Zähler Z_{I} um die dritte Schrittweite INC₃ - im Beispiel zunächst um 1 - dekrementiert.

Anschließend oder wenn der erste Zähler dem vorbestimmten (Anfangs-) Wert entspricht wird in Schritt 200 der Strom I gemessen.

Der gemessen Strom I wird in Schritt 300 mit dem ersten Strom-Schwellwert I_{ref,1} verglichen. Im Beispiel wird angenommen, dass der erste Strom-Schwellwert z.B. dem 1.1 fachen des Nennstromes durch die Vorrichtung entspricht.

Ist der gemessene Strom I kleiner als der erste Strom-Schwellwert I_{ref,1} kehrt das Verfahren zu Schritt 100 zurück.

Ist der gemessene Strom I größer als der erste Strom-Schwellwert I_{ref,1} wird der erste Zähler Z_{I} in Schritt 400 um die erste Schrittweite INC₁ - im Beispiel zunächst um 1 - inkrementiert.

Der gemessen Strom I wird in Schritt 500 mit dem zweiten Strom-Schwellwert I_{ref,2} verglichen.

Ist der gemessene Strom I größer als der zweiten Strom-Schwellwert I_{ref,2} wird der erste Zähler Z_{I} in Schritt 550 um die zweite Schrittweite INC₂ - im Beispiel zunächst um 5 - inkrementiert.

Anschließend oder wenn der gemessene Strom I kleiner als der zweiten Strom-Schwellwert I_{ref,2} ist, wird in Schritt 600 (optional) eine vorbestimmte Zeit abgewartet oder aber unmittelbar der Schalter SW in Schritt 650 so angesteuert wird, dass er öffnet.

Nunmehr kann in Schritt 700 überprüft werden, ob der erste Zähler einen bestimmten ersten Zählergrenzwertes Z_{I,MAX} erreicht hat. Vorliegend könnte dieser Wert z.B. 40 sein.

Ist der Wert erreicht, so wird der Schalter nicht wieder eingeschaltet und das Verfahren endet.

Ist hingegen der erste Zählergrenzwert Z_{I,MAX} nicht erreicht wird in Schritt 800 eine vorbestimmte Zeit tₐᵤₛ abgewartet und anschließend mit Schritt 200 fortgefahren.

Ohne weiteres versteht es sich, dass die Bedingungen des Überschreitens auch durch andere Bedingungen äquivalent ersetzt werden können.

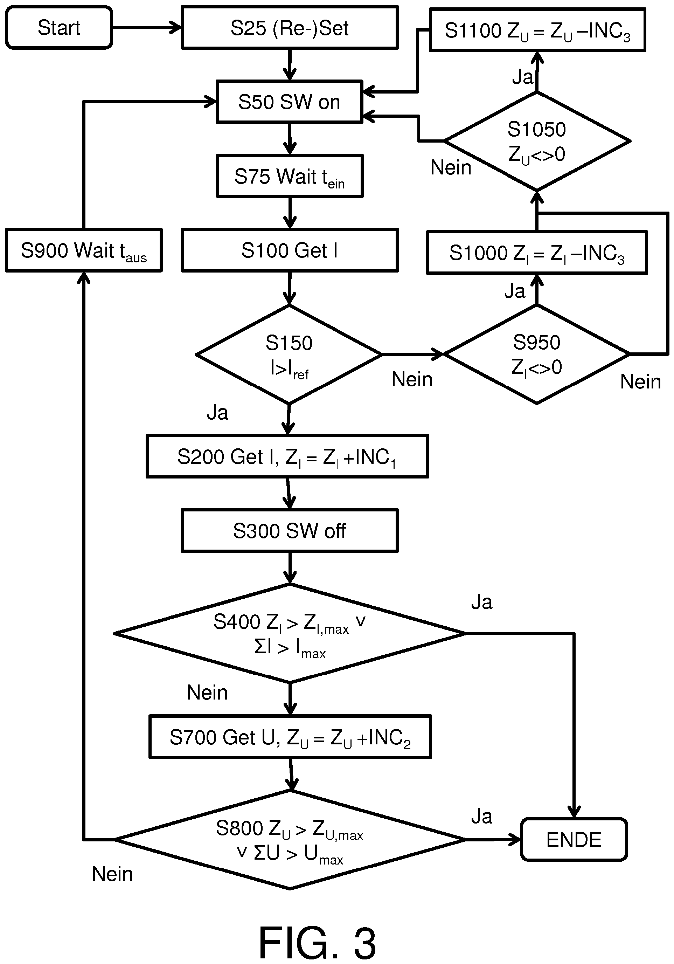

In einer weiteren Ausführungsform der Erfindung weist die Vorrichtung 1 wiederum einen Strommesser U_{R}, einen ersten Zähler Z_{I}, einen zweiten Zähler Z_{U}, einen Spannungsmesser Usw und einen Schalter SW auf. Das zugehörige Verfahren wird in Bezug auf Figur 3 erläutert werden.

Dabei misst der Strommesser U_{R} einen Strom I durch die Vorrichtung 1. Hierfür ist im Prinzip jede Form der Strommessung möglich, sei es durch ein induziertes magnetisches Feld (z.B. Rogowski-Spule, Hall-Sensor) oder aber durch Spannungsmessung an einem Shunt-Widerstand R oder dergleichen.

Der Schalter SW ist geeignet einen Stromfluss durch die Vorrichtung 1 zu unterbrechen. Im Prinzip können hier jegliche Art von Schalter zum Einsatz kommen, z.B. ein mechanischer Schalter oder ein elektrischer Schalter, z.B. ein gesteuerter (Feld-Effekt-) Transistor.

Weiterhin verwendet die Vorrichtung einen Spannungsmesser Usw, der eine Spannung über den Schalter SW misst. Da der Schalter SW im idealisierten Fall einen Kurzschluss darstellt, reicht es aus Spannungen im geöffneten Zustand des Schalters SW zu messen, da bei geschlossenem Schalter SW die Spannung null sein sollte.

Je nach Art des Schalters SW kann jedoch auch vorgesehen sein, dass z.B. der Schalter SW selbst einen geringen Widerstand darstellt, sodass die Strommessung beispielsweise den geschlossen Schalter als Shunt-Widerstand R verwenden könnte. Ein solcher Fall kann z.B. bei Verwendung von Halbleiter-Schaltern (z.B. gesteuerter (Feld-Effekt-) Transistor) auftreten.

Insofern ist die zuvor beschriebene Aufteilung funktional zu verstehen und beschränkt nicht die tatsächliche Realisierung.

Wenn der Strommesser in Schritt S100 einen Strom I misst, der einen ersten Schwellwert I_{ref,1} übersteigt (Schritt S150), wird der erste Zähler Z_{I} in Schritt S200 um eine erste Schrittweite INC₁ in eine erste Richtung geändert und der Schalter in Schritt S300 so angesteuert, dass der Stromfluss unterbrochen wird.

Offensichtlich können auch mehrere Strom-Schwellwerte entsprechend Figur 2 vorgesehen sein. Auch kann die tatsächliche Implementierung des Vergleiches mit zwei oder mehreren Schwellwerten in einem Verarbeitungsschritt realisiert sein.

Der erste Zähler Z_{I} wird nach einer Zähleränderung mit einem ersten Zählergrenzwert Z_{I,MAX} in Schritt S400 verglichen, wobei bei Erreichen oder Überschreiten des ersten Zählergrenzwertes Z_{I,MAX}, der Schalter dauerhaft so angesteuert wird, dass der Stromfluss unterbrochen wird und das Verfahren endet.

Andernfalls wird in Schritt S700 der zweite Zähler Zu um eine zweite Schrittweite INC₂ in eine dritte Richtung + geändert. Die zweite Schrittweite INC₂ kann z.B. der durch den Spannungsmesser gemessenen Spannung entsprechen.

Hierzu kann zudem vorgesehen sein, dass die Spannung am Schalter Usw mit der tatsächlichen Quelllenspannung U_{N} auf Seiten des Netzes verglichen wird. Hierdurch können etwaige Spannungsschwankungen im Netz besser berücksichtigt werden.

Wiederum kann die zweite Schrittweite INC₂ auch abhängig von der Größe der Abweichung sein. Beispielsweise könnte bei einem Vergleich dahingehend, dass 95 % der (erwarteten oder gemessenen) Quelllenspannung U_{N} überschritten wird, der zweite Zähler Z_{U} um einen ersten Wert (z.B. 100) inkrementiert werden, während im Falle, dass 95 % der (erwarteten oder gemessenen) Quelllenspannung U_{N} unterschritten werden, der zweite Zähler Z_{U} um einen zweiten Wert (z.B. 10)) inkrementiert wird.

Offensichtlich können auch mehrere Spannungs-Schwellwerte vorgesehen sein. Auch kann die tatsächliche Implementierung des Vergleiches mit zwei oder mehreren Schwellwerten in einem Verarbeitungsschritt realisiert sein.

In einem nachfolgendem Schritt S800 wird der zweite Zähler Zu nach einer Zähleränderung mit einem zweiten Zählergrenzwert Z_{U,MAX} verglichen, wobei bei Erreichen oder Überschreiten des zweiten Zählergrenzwertes Z_{U,MAX} der Schalter SW dauerhaft so angesteuert wird, dass der Stromfluss unterbrochen wird und das Verfahren endet.

Andernfalls wird in Schritt S900 abgewartet und das Verfahren kehrt zu Schritt 50 zurück.

In einer weiteren vorteilhaften Ausgestaltung der Erfindung wird, wenn der Strommesser nachfolgend zu einer temporären Unterbrechung des Stromflusses einen Strom in Schritt 100 misst, der den ersten Schwellwert I_{ref,1} nicht übersteigt, der erste Zähler Z_{I} um eine dritte Schrittweite INC₃ in eine zweite Richtung in Schritt S1000 geändert. Die zweite Richtung ist dabei unterschiedlich von der ersten Richtung. Weiterhin wird in Schritt S1100 der zweite Zähler Z_{U} um eine vierte Schrittweite INC₄ in eine vierte Richtung geändert, wobei die vierte Richtung unterschiedlich ist von der dritten Richtung.

Beiden "Rückführungs"-Operationen S1000 und S1100 kann je nach Art des Zählers eine Überprüfung in Schritten S950 bzw. S1050 vorgeschaltet sein, um z.B. einen Zählerüberlauf oder dergleichen zu vermeiden.

In einer weiteren vorteilhaften Ausgestaltung der Erfindung weist die Vorrichtung 1 weiterhin Setzmittel für die Zähler auf, die den ersten Zähler Z_{I} auf einen vorbestimmten Zählerwert zu Beginn des Betriebes in Schritt S25 setzen. Beispielsweise kann der erste Zähler Z_{I} und der zweite Zähler Zu jeweils auf 0 gesetzt werden.

Ohne weiteres können die einzelnen Schritte auch in anderer sinnvoller Weise gruppiert oder in einem Teilschritt zusammengefasst oder in mehrere Teilschritte unterteilt sein. Insofern sind die dargestellten Schritte beispielhaft. Auch können die zuvor in Bezug auf Figur 2 bzw. Figur 3 diskutierten Aspekte auch in der jeweiligen anderen Ausführung Anwendung finden.

Die vorstehend erwähnten Schritte bzw. Mittel können Bestandteil einer Steuereinheit SE sein bzw. von ihr ausgeführt werden. Eine Steuereinheit kann z.B. ein Mikrocontroller oder einer ASIC oder ein FPGA sein.

**Bezugszeichenliste**

| | |
|---|---|
| Vorrichtung | 1 |
| Strommesser | U_{R} |
| Spannungsmesser | U_{SW} |
| Schalter | SW |
| erster / zweiter Strom-Schwellwert | I_{ref,2}, I_{ref,1} |
| erster / zweiter Zähler | Z_{I}, Z_{U} |
| erster / zweiter Zählergrenzwert | Z_{I,MAX} ,Z_{U,MAX} |
| vorbestimmte Zeit | tₐᵤₛ |
| Schwellwert | U_{ref} |
| Strom | I |
| Shunt-Widerstand | R |
| Berechnungseinheit | SE |
| Last | V |
| erste/zweite/dritte/vierte Schrittweite | INC₁, INC₂, INC₃, INC₄ |

## Patentansprüche

1. Vorrichtung (1) zur Detektion eines Überstromes, aufweisend
• einen Strommesser (U_{R}), einen ersten Zähler (Z_{I}), einen zweiten Zähler (Z_{U}), einen Spannungsmesser (U_{SW}) und einen Schalter (SW),
• wobei der Strommesser (U_{R}) einen Strom (I) durch die Vorrichtung (1) misst, wobei der Schalter (SW) geeignet ist einen Stromfluss durch die Vorrichtung (1) zu unterbrechen, wobei der Spannungsmesser (Usw) eine Spannung über den Schalter (SW) misst,
• wobei, wenn der Strommesser einen Strom (I) misst (S100), der einen ersten Schwellwert (I_{ref,1}) übersteigt, der erste Zähler (Z_{I}) um eine erste Schrittweite (INC₁) in eine erste Richtung (+) geändert wird (S200) und der Schalter so angesteuert wird (S300), dass der Stromfluss unterbrochen wird
• wobei der erste Zähler (Z_{I}) nach einer Zähleränderung mit einem ersten Zählergrenzwert (Z_{I,MAX}) verglichen wird (S400), wobei bei Erreichen oder Überschreiten des ersten Zählergrenzwertes (Z_{I,MAX}), der Schalter dauerhaft so angesteuert wird, dass der Stromfluss unterbrochen wird, und andernfalls (S700) der zweite Zähler (Z_{U}) um eine zweite Schrittweite (INC₂) in eine dritte Richtung (+) geändert wird, wobei die zweite Schrittweite der durch den Spannungsmesser gemessenen Spannung entspricht, wobei der zweite Zähler (Zu) nach einer Zähleränderung mit einem zweiten Zählergrenzwert (Z_{U,MAX}) verglichen (S800) wird, wobei bei Erreichen oder Überschreiten des zweiten Zählergrenzwertes (Z_{U,MAX}), der Schalter (SW) dauerhaft so angesteuert wird, dass der Stromfluss unterbrochen wird, und andernfalls der Schalter (SW) nach einer vorbestimmte Zeit (tₐᵤₛ) so angesteuert wird (S900), dass der Stromfluss nicht mehr unterbrochen ist.

2. Vorrichtung nach Anspruch 1, wobei, wenn der Strommesser nachfolgend zu einer temporären Unterbrechung des Stromflusses einen Strom misst (S100), der den ersten Schwellwert (I_{ref,1}) nicht übersteigt, der erste Zähler (Z_{I}) um eine dritte Schrittweite (INC₃) in eine zweite Richtung (-) geändert wird (S1000), wobei die zweite Richtung (-) unterschiedlich ist von der ersten Richtung (+), und wobei der zweite Zähler (Zu) um eine vierte Schrittweite (INC₄) in eine vierte Richtung (-) geändert wird (S1100), wobei die vierte Richtung (-) unterschiedlich ist von der dritten Richtung (+).

3. Vorrichtung nach Anspruch 1 oder 2, weiterhin aufweisend Setzmittel für den ersten Zähler (Z_{I}), die den ersten Zähler (Z_{I}) auf einen vorbestimmten Zählerwert zu Beginn des Betriebes setzen (S25).

4. Vorrichtung nach Anspruch 1 oder 2 oder 3, weiterhin aufweisend Setzmittel für den zweiten Zähler (Z_{U}), die den zweiten Zähler (Z_{U}) auf einen vorbestimmten Zählerwert ("0") zu Beginn des Betriebes setzen (S25).

## Claims

1. A device (1) for detecting an overcurrent, having
• a current meter (U_{R}), a first counter (Z_{I}), a second counter (Z_{U}), a voltmeter (U_{SW}), and a switch (SW),
• wherein the current meter (U_{R}) measures a current (I) through the device (1), with the switch (SW) being capable of interrupting a current flow through the device (1) and with the voltmeter (U_{SW}) measuring a voltage via the switch (SW),
• wherein, if the current meter measures a current (I) (S100) that exceeds a first threshold (I_{ref,1}), the first counter (Z_{I}) is changed by a first increment (INC₁) in a first direction (+) (S200) and the switch is actuated (S300) such that the current flow is interrupted,
• wherein, after a change in the counter, the first counter (Z_{I}) is compared with a first counter threshold (Z_{I,MAX}) (S400), and if the first counter threshold (Z_{I,MAX}) has been reached or exceeded, the switch is actuated continuously such that the current flow is interrupted, and otherwise (S700) the second counter (Z_{U}) is changed by a second increment (INC₂) in a third direction (+) that corresponds to the voltage measured by the voltmeter, wherein, after a change in the counter, the second counter (Zu) is compared with a second counter threshold (Z_{U,MAX}) (S800), and if the second counter threshold (Z_{U,MAX}) has been reached or exceeded, the switch (SW) is continuously actuated such that the current flow is interrupted, and otherwise the switch (SW), after a predetermined time (toff), is actuated (S900) such that the current flow is no longer interrupted.

2. The device as set forth in claim 1, wherein, subsequently to a temporary interruption of the current flow, if the current meter measures a current (S100) that does not exceed the first threshold (I_{ref,1}), the first counter (Z_{I}) is changed by a third increment (INC₃) in a second direction (-) (S1000), wherein the second direction (-) is different from the first direction (+), and wherein the second counter (Z_{U}) is changed by a fourth increment (INC₄) in a fourth direction (-) (S1100), with the fourth direction (-) being different from the third direction (+).

3. The device as set forth in claim 1 or 2, further comprising a setting means for the first counter (Z_{I}) which sets the first counter (Z_{I}) to a predetermined counter value at the beginning of operation (S25).

4. The device as set forth in claim 1 or 2 or 3, further comprising a setting means for the second counter (Z_{U}) which sets the second counter (Z_{U}) to a predetermined counter value ("0") at the beginning of operation (S25).

## Revendications

1. Dispositif (1) pour la détection d'une surintensité de courant, présentant :
* un ampèremètre (U_{R}), un premier compteur (Z₁), un deuxième compteur (Z_{U}), un voltmètre (U_{SW}) et un commutateur (SW),
* dans lequel l'ampèremètre (U_{R}) mesure un courant (I) à travers le dispositif (1), dans lequel le commutateur (SW) est adapté pour interrompre une circulation de courant à travers le dispositif (1), dans lequel le voltmètre (U_{SW}) mesure une tension au commutateur (SW),
* dans lequel, lorsque l'ampèremètre mesure (S100) un courant (I) qui dépasse une première valeur de seuil (I_{ref,1}), le premier compteur (Z₁) subit une modification (S200) de l'ordre d'un premier incrément (INC₁) dans une première direction (+) et le commutateur est commandé (S300) de manière à ce que la circulation de courant est interrompue,
* dans lequel le premier compteur (Z₁), après une modification de compteur, est comparé (S400) avec une première valeur de seuil de compteur (Z_{I,MAX}), dans lequel, en cas d'atteinte ou de dépassement de la première valeur de seuil de compteur (Z_{I,MAX}), le commutateur est commandé en permanence de manière à interrompre la circulation de courant, et sinon (S700) le deuxième compteur (Zu) subit une modification de l'ordre d'un deuxième incrément (INC₂) dans une troisième direction (+), dans lequel le deuxième incrément correspond à la tension mesurée par le deuxième voltmètre, dans lequel, après une modification de compteur, le deuxième compteur (Zu) est comparé (S800) avec une deuxième valeur de seuil de compteur (Z_{U,MAX}), dans lequel, lors de l'atteinte ou du dépassement de la deuxième valeur de compteur (Z_{U,MAX}), le commutateur (SW) est commandé en permanence de manière à interrompre la circulation de courant et sinon, après une durée prédéfinie (tₐᵤₛ), le commutateur (SW) est commandé (S900) de manière à ne plus interrompre la circulation de courant.

2. Dispositif selon la revendication 1, dans lequel, lorsque l'ampèremètre mesure ensuite (S100), pour une interruption temporaire de la circulation de courant, un courant qui ne dépasse pas la première valeur de seuil (I_{ref,1}), le premier compteur (Z_{I}) subit une modification (S1000) de l'ordre d'un troisième incrément (INC₃) dans une deuxième direction (-), dans lequel la deuxième direction (-) est différente de la première direction (+), et dans lequel le deuxième compteur (Zu) subit une modification (S1100) de l'ordre d'un quatrième incrément (INC₄) dans une quatrième direction (-), dans lequel la quatrième direction (-) est différente de la troisième direction (+).

3. Dispositif selon la revendication 1 ou 2, présentant en outre des moyens de réglage pour le premier compteur (Z_{I}), lesquels règlent (S25) le premier compteur (Z_{I}) à une valeur de compteur prédéfinie au début du fonctionnement.

4. Dispositif selon la revendication 1 ou 2 ou 3, présentant en outre des moyens de réglage pour le deuxième compteur (Zu), lesquels règlent (S25) le deuxième compteur (Zu) à une valeur de comptage (« 0 ») prédéfinie au début du fonctionnement.
